# EUROPÄISCHE PATENTANMELDUNG

(11) **EP 0 699 020 A1**
(43) Veröffentlichungstag der Anmeldung: **28.02.1996**
(21) Anmeldenummer: 95113102.8
(22) Anmeldetag: 21.08.1995
(51) Int. Cl.: H05K 7/20, H05K 1/02, H05K 3/40

(54) **Durchkontaktierungen aufweisende Leiterplatte**

(30) Priorität: 26.08.1994 DE 9413819 U
(71) Anmelder: Blaupunkt-Werke GmbH, D-31132 Hildesheim (DE)
(72) Erfinder: Dobers, Michael, Dr., D-31134 Hildesheim (DE)

(57) **Zusammenfassung**

Erfindungsgemäß werden für eine beidseitig kaschierte Leiterplatte Durchkontaktierungen vorgeschlagen, bei denen die Kontaktbrücken aus einer gehärteten Leitpaste zur elektrisch leitenden Verbindung der vorgesehenen Leiterbahnen aufgebracht wird. Die Kontaktbrücken werden derart großflächig ausgebildet, daß sie die Funktion von wärmeabführenden Kühlkörpern übernehmen (Figur 1).

## Beschreibung

Die Erfindung betrifft eine Durchkontaktierungen aufweisende, beidseitig mit Leiterbahnen versehen/e Leiterplatte, bei der in Durchgangsbohrungen angeordnete, aus einer Leitpaste gebildete Kontaktbrücken auf gegenüberliegenden Leiterplattenflächen vorgesehene Leiterbahnen elektrisch leitend miteinander verbinden.

Derartige, mit üblichen Leiterbahnenmustern versehene Leiterplatten, bei denen die Kontaktbrücken mittels einer Leitpaste gebildet werden, sind zwar preiswert in der Herstellung, jedoch nur für geringe Stromstärken geeignet. Die aus einer Leitpaste gebildeten Kontaktbrücken besitzen einen geringen, jedoch nicht verschwindenden elektrischen Widerstand. Dieses hat zur Folge, daß die Kontaktbrücken durch einen sie durchfließenden elektrischen Strom erwärmt werden können. Bei relativ hohen Strömen kann die Erwärmung zu einer Zerstörung der Durchkontaktierung führen.

Für erhöhte Strombelastungen lassen sich zwar in vorteilhafter Weise Leitplatten verwenden, bei denen die elektrische Kontaktierung beispielsweise über eine mit den Leiterbahnen verbundene metallische Kupferhülse erfolgt. Derartige Leiterplatten sind jedoch infolge ihrer aufwendigen Herstellung relativ teuer.

Der Erfindung liegt die Aufgabe zugrunde, eine wenig aufwendige, für höhere Strombelastungen geeignete, Durchkontaktierungen aufweisende Leiterplatte anzugeben.

Diese Aufgabe wird erfindungsgemäß dadurch gelöst, daß die mittels einer Kontaktbrücke beidseitig verbundenen Leiterbahnen mindestens im Nahbereich der Kontaktbrücke derart großflächig ausgebildet sind, daß sie für die mit ihnen verbundene Kontaktbrücke die Funktion von wärmeabführenden Kühlkörpern übernehmen.

Die mit der Erfindung erzielten Vorteile bestehen insbesondere darin, daß eine mit preiswerten Durchkontaktierungen versehene Leiterplatte nunmehr auch für höhere Strombelastungen geeignet ist.

Vorteilhafte Ausgestaltung der Erfindung sind in den Unteransprüchen angegeben. Mit einer Ausgestaltung nach Anspruch 2 läßt sich eine erheblich verbesserte Kühlwirkung bei einer optimalen Platzausnutzung erzielen. Mit einer Ausgestaltung nach Anspruch 3 lassen sich platzsparende Schachtelungen der Leiterbahnenanschlüsse durchführen. Für extreme Strombelastungen ist eine Ausgestaltung nach Anspruch 4 besonders geeignet.

Ausführungsbeispiele der Erfindung sind in der Zeichnung dargestellt und werden im folgenden näher erläutert.

Es zeigen:
- Fig. 1: eine geschnittene Seitenansicht einer mit einer Durchkontaktierung versehenen, beidseitig Leiterbahnen aufweisenden Leiterplatte und
- Fig. 2 bis Fig. 5: mögliche Ausgestaltungen von mit Durchkontaktierungen versehenen Leiterbahnen in der Draufsicht.

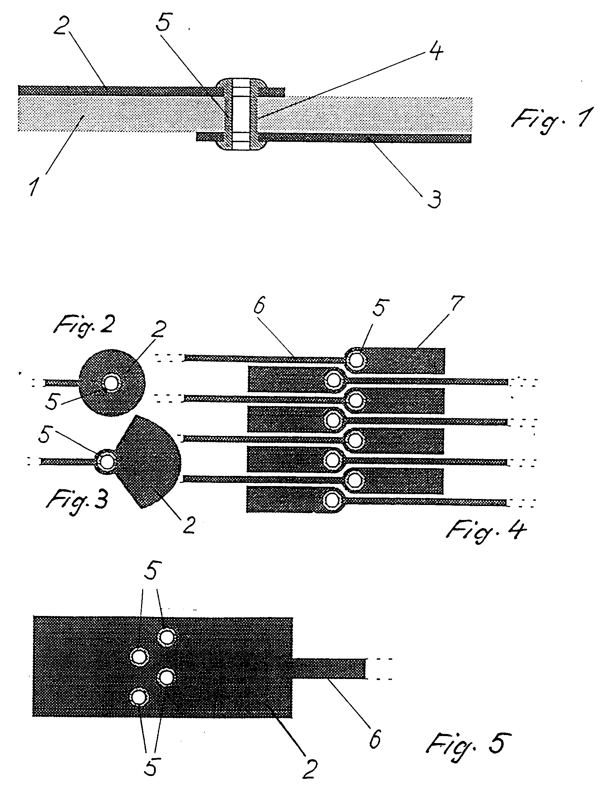

Eine aus einem Isolierstoff gefertigte Leiterplatte 1 nach Fig. 1 weist auf ihrer Oberseite mindestens eine aus einer Kupferauflage gebildete Leiterbahn 2 und auf ihrer Unterseite mindestens eine aus einer Kupferauflage gebildete Leiterbahn 3 auf. Beide Leiterbahnen 2, 3 sowie die Leiterplatte 1 werden von einer Durchgangsbohrung 4 durchdrungen, in der eine die beiden Leiterbahnen 2, 3 elektrisch verbindende Kontaktbrücke 5 angeordnet ist. Die aus einer ausgehärteten Silberleitpaste bestehende, hülsenförmig ausgebildete Kontaktbrücke 5 umgreift mit ihren Endabschnitten flanschartig die Randbereiche der Leiterbahnenbohrungen. Eine derartige Durchkontaktierung ist beispielsweise aus der Patentanmeldung Az: P 43 18604.1 bekannt.

Da aus einer Silberleitpaste bestehende Kontaktbrücken 5 sich bei einer Strombelastung wesentlich stärker erwärmen, als mit ihnen verbundene übliche Leiterbahnen 2, 3, sind derartige Leiterplatten 1 nur für geringe Stromstärken geeignet. Durch die erfindungsgemäße Ausbildung der Leiterbahnen 2,3, bei der diese im Nahbereich der ihnen zugeordneten Kontaktbrücke 5 derart großflächig ausgebildet sind, daß sie für die mit ihnen verbundene Kontaktbrücke 5 die Funktion von wärmeabführenden Kühlkörpern übernehmen, ist eine wesentlich höhere Strombelastung der Leiterplatten möglich. So können die Leiterbahnen 2, 3 im Bereich einer Kontaktbrücke 5 beispielsweise nach Fig. 2 als Kreisfläche oder nach Fig. 3 als Kreissektor ausgebildet sein. Für eine enge Gruppierung von Durchkontaktierupgen ist eine Ausbildung nach Fig. 4 besonders geeignet, bei der die Leiterbahnen 2, 3 einen als elektrischen Leiter dienenden ersten Abschnitt 6 und einen sich über die Kontaktbrücke 5 hinaus erstreckenden, lediglich zur Wärmeabfuhr dienenden zweiten Abschnitt 7 aufweisen. Für hohe Strombelastungen können zur Kontaktierung zweier Leiterbahnen 2, 3 mehrere Kontaktbrücken 5 nach Fig. 5 vorgesehen werden.

## Patentansprüche

1. Durchkontaktierungen aufweisende, beidseitig mit Leiterbahnen versehene Leiterplatte, bei der in Durchgangsbohrungen angeordnete, aus einer ausgehärteten Leitpaste gebildete Kontaktbrücken auf gegenüberliegenden Leiterplattenflächen vorgesehene Leiterbahnen elektrisch leitend miteinander verbinden,
dadurch gekennzeichnet,
das die mittels einer Kontaktbrücke (5) beidseitig verbundenen Leiterbahnen (2,3) mindestens im Nahbereich der Kontaktbrücke (5) derart großflächig ausgebildet sind, daß sie für die mit ihnen verbundene Kontaktbrücke (5) die Funktion von wärmeabführenden Kühlkörpern übernehmen.

2. Durchkontaktierungen aufweisende beidseitig mit Leiterbahnen versehene Leiterplatte nach Anspruch 1,
dadurch gekennzeichnet,
daß die über Kontaktbrücken (5) verbundenen Leiterbahnen (2,3) derart ausgebildet sind, daß sie einen als elektrischen Leiter dienenden ersten Abschnitt (6) und einen sich über den Kontaktbrückenanschlußpunkt (5) hinaus erstreckenden, lediglich zur Wärmeabfuhr dienenden zweiten Abschnitt (7) aufweisen.

3. Durchkontaktierungen aufweisende beidseitig mit Leiterbahnen versehene Leiterplatte nach Anspruch 2,
dadurch gekennzeichnet,
daß die zweiten Abschnitte (7) wesentlich breiter als die ersten Abschnitte (6) ausgeführt sind.

4. Durchkontaktierungen aufweisende beidseitig mit Leiterbahnen versehene Leiterplatte nach einen der Ansprüche 1 bis 3,
dadurch gekennzeichnet,
daß zur Kontaktierung zweier Leiterbahnen (2,3) mehrere Kontaktbrükken (5) vorgesehen sind.
